## Europäisches Patentamt

## European Patent Office

## Office européen des brevets

(11) Veröffentlichungsnummer: **0 141 080**
**B1**

(19)

(12) # EUROPÄISCHE PATENTSCHRIFT

(45) Veröffentlichungstag der Patentschrift:
08.04.87

(21) Anmeldenummer: **84109449.3**

(22) Anmeldetag: **08.08.84**

(51) Int. Cl.⁴: **G 01 R 17/06,** G 01 R 17/10, G 01 G 3/147

(54) **Auswerteschaltungen für passive Messgrössenaufnehmer.**

(30) Priorität: **26.08.83 DE 3330841**

(43) Veröffentlichungstag der Anmeldung:
**15.05.85 Patentblatt 85/20**

(45) Bekanntmachung des Hinweises auf die Patenterteilung:
**08.04.87 Patentblatt 87/15**

(84) Benannte Vertragsstaaten:
**AT BE CH DE FR GB IT LI LU NL SE**

(56) Entgegenhaltungen:
DE-A-2 260 441
DE-B-2 841 830

**PROCEEDINGS IEE, Band 119, Nr. 1, Januar 1972, Seiten 108-112; S. SUZUKI: "Square-wave-source gated-detector bridge system for the precise measurement of resistance"**
**ELECTRONIC DESIGN, Band 29, Nr. 16, August 1981, Seiten 203-206, Waseca, MN, USA; J. WILLIAMS: "IC instrumentation amp enhances transducer measurements"**

(73) Patentinhaber: **Siemens Aktiengesellschaft Berlin und München, Wittelsbacherplatz 2, D-8000 München 2 (DE)**

(72) Erfinder: **Horn, Klaus, Prof. Dr.- Ing., Sanddornweg 10 a, D-3300 Braunschweig (DE)**

EP 0 141 080 B1

LIBER, STOCKHOLM 1987

**Beschreibung**

Die Erfindung bezieht sich auf Auswerteschaltungen für passive Meßgrößenaufnehmer mit ohmschen Fühlerwiderständen in Brückenschaltungen mit einem Abgleich der Ausgangssignale der Aufnehmer durch dauermoduliertes Umschalten eines Widerstandes, der vom Überlaufsignal eines Taktimpulszählers in die eine Umschaltlage und vom Ausgangssignal eines digitalen Vergleichers der Inhalte des Taktimpulszählers und eines an den Ausgang eines vorzeichenempfindlichan Spannungs-Frequenz-Umformers, dessen Eingangsspannung aus einem verstärkten, mit einem phasenempfindlichen Gleichrichter gleichgerichteten und durch einen Tiefpaß gefilterten Abgleichdifferenzsignal besteht, angeschlossenen Vor-Rückwärtszählers in die andere Umschaltlage gesteuert wird, bei denen die Aufnehmer und der umschaltbare Widerstand mit einem vom Überlauf des Taktimpulszählers gesteuerten Polumschalter aus einer Gleichstrom- oder Gleichspannungsquelle gespeist sind und der phasenempfindliche Gleichrichter synchron mit dem Polumschalter gesteuert ist.

Eine derartige Auswerteschaltung ist aus der DE-PS 22 62 755 bekannt. Die dort digitale Kompensationseinrichtung genannte Auswerteschaltung soll im Ergebnis frei von Auswirkungen von Thermospannungen und Kontaktpotentialen im passiven Meßgrößenaufnehmer sein und unabhängig von der Nullpunktsdrift eines sogenannten Nullverstärkers.

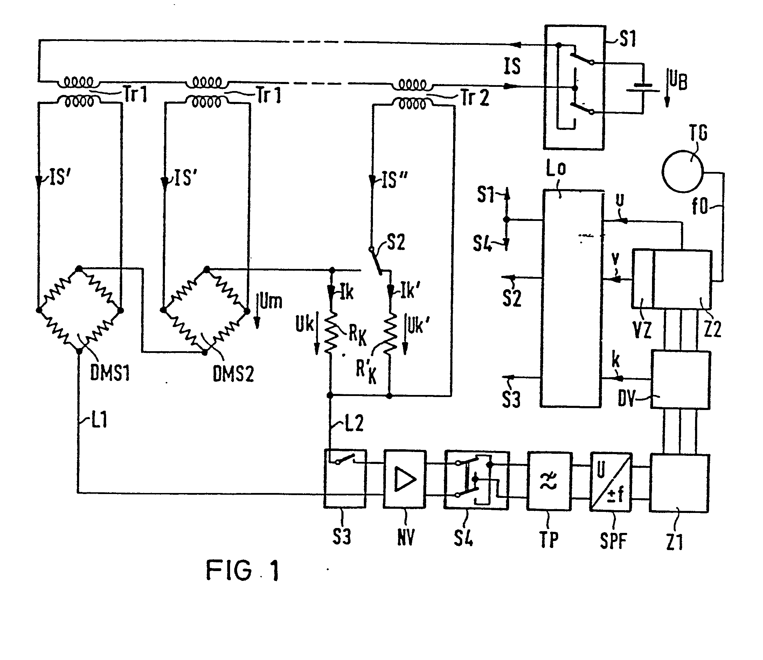

Um die mit der Erfindung gegenüber dieser bekannten Schaltung angestrebten Verbesserungen besser verständlich zu machen, ist es angebracht, die bekannte Schaltung kritisch zu würdigen. Deshalb wird die bekannte Schaltung in einer Figur 1 nochmals dargestellt. In dieser Figur 1 sind zwei Meßgrößenaufnehmer DMS1, DMS2 zu erkennen, die aus Brückenschaltungen bestehen, deren Speisediagonalen über Sekundärwicklungen eines Stromwandlers Tr1 mit Strömen IS' gespeist werden. Die Meßdiagonalen der Meßgrößenaufnehmer DMS1 und DMS2 sind in Reihe geschaltet. Die an den Diagonalen liegende Summenspannung ist mit Um bezeichnet. Dieser Summenspannung ist eine Kompensationsspannung Uk entgegengeschaltet, die an einem Kompensationswiderstand R abfällt. Der Kompensationswiderstand R ist über einen Umschalter S2 an die Sekundärwicklung eines zweiten Stromwandlers Tr2 anschließbar, durch welche ein Strom IS'' fließt. Ein zweiter Kontakt des Umschalters S2 liegt an einem Widerstand R', der über den Umschalter wechselweise mit dem Widerstand R in den Sekundärstromkreis des Wandlers Tr2 eingeschaltet werden kann. Die Primärwicklungen der Stromwandler Tr1 und Tr2 liegen in Serie über einen Polumschalter S1 an einer Gleichstromquelle. In den Primärwicklungen fließt der Strom IS. Die Differenz der Spannungen Um und Uk wird über Leitungen L1 und L2 einem Schalter S3 zugeführt, der einem Nullverstärker NV vorgeschaltet ist. An den Ausgangsklemmen des Nullverstärkers liegt ein zweiter Polumschalter S4. Seine Ausgangsklemmen sind über einen Tiefpaß TP mit den Eingangsklemmen eines Spannungs-Frequenz-Umformers SPF verbunden. Der Polumschalter S4 wird synchron mit dem Polumschalter S1 betätigt, so daß er als Kontaktgleichrichter wirkt. Die Ausgangsklemmen des Spannungs-Frequenz-Umformers SPF sind mit den Vor- und Rückwärtseingängen eines Impulszählers Z1 verbunden. Der Zähleingang eines Taktimpulszählers Z2 ist an den Ausgang eines Taktgenerators angeschlossen, der eine Impulsfolge mit der Folgefrequenz f0 liefert. Die Dekadenausgänge der Zähler Z1 und Z2 sind mit Vergleichseingängen einer digitalen Vergleichsschaltung DV verbunden. Ein Ausgang der Vergleichsschaltung DV, der einen die Übereinstimmung der Zählerinhalte z1 und z2 markierenden Impuls k führt, ist an den Eingang einer Schaltsteuerlogik Lo angeschlossen. Ein Übertragsimpuls ü gelangt über eine Verbindungsleitung der höchsten Dekade des Taktimpulszählers Z2 an einen zweiten Eingang der Schaltsteuerlogik Lo. Einem weiteren Eingang der Schaltsteuerlogik ist ein Übertragsimpuls v eines Vortaktzählers VZ zugeführt. Ein Ausgang der Schaltsteuerlogik steuert gleichzeitig die beiden Polumschalter S1 und S4. Zwei weitere Ausgänge der Schaltsteuerlogik dienen der Steuerung der Schalter S2 bzw. S3.

Mit dem Schalter S1 wird über die Schaltsteuerlogik Lo jedesmal, wenn der Taktimpulszähler Z2 von den Taktimpulsen des Taktimpulsgenerators TG auf seinen Zählerendwert $z2_{max}$ hochgezählt ist und einen Übertragsimpuls ü abgibt, die Polarität der Speisespannung bzw. des Speisestromes gewechselt.

Über die Schaltsteuerlogik Lo wird der Schalter S2 in dem Augenblick auf den Widerstand R' umgeschaltet, in dem der Taktimpulszähler Z2 den gleichen Inhalt wie der Zähler Z1 hat und damit die digitale Vergleichsschaltung DV mit einem Impuls k die Koinzidenz der Zählerinhalte an die Schaltsteuerlogik Lo meldet. Der arithmetische Mittelwert Ūk der auf diese Weise gewonnenen Kompensationsspannung Uk ist damit direkt proportional dem momentanen Zählerinhalt z1 des Zählers Z1, bezogen auf den maximalen Zählerinhalt $z2_{max}$ des Taktimpulszählers Z2.

Der Unterbrecherschalter S3, der von der Schaltsteuerlogik Lo im gleichen Augenblick wie der Schalter S2 um die Zeit $\Delta t$ gegenüber den Umschaltzeitpunkten des Speisestromes verschoben durchgeschaltet wird, bleibt über einen ganzen Abfragetakt

$$T_A = z2_{max} \cdot \tfrac{1}{f0}$$

bis zum nächsten Übertragsimpuls ü des Taktimpulszählers Z2 durchgeschaltet. Der Nullverstärker NV, vor dessen Eingang der Schalter S3 liegt, erhält demnach die Differenzspannung $\Delta U$.

Es hat sich herausgestellt, daß sich mit dieser bekannten Schaltung der angestrebte Erfolg aus folgenden Gründen nur sehr unzulänglich erreichen läßt.

Als automatisch abgleichende Kompensationseinrichtung ist die in Figur 1 wiedergegebene bekannte Schaltung in ihrem Aufbau ein geschlossener Regelkreis, in dem der Nullverstärker NV, der in der Regelungstechnik Regelverstärker genannt wird, zur möglichst selektiven Verstärkung der Regelabweichung dient. Diese Regelabweichung soll hier $\Delta \bar{U}$ genannt werden. Sie stellt die Differenz der jeweils über eine Schaltdauer $T_A$ gebildeten arithmetischen Mittelwerte der Aufnehmersignalspannungssumme $\bar{Um}$ und der Kompensationsspannung $\bar{Uk}$

$$\Delta \bar{U} = \bar{Um} - \bar{Uk}$$

dar. Durch die mit jeder Umschaltung des Polumschalters S1 gewechselte Polarität der Speiseströme IS haben $\Delta \bar{U}$ und alle sonstigen auf den Eingang des Nullverstärkers NV wirkenden Komponenten der Differenzspannung $\Delta U$ in zwei aufeinanderfolgenden Schaltzeiten $T_{An}$ und $T_{An+1}$ bei gleichem Betrag entgegengesetztes Vorzeichen. $\Delta \bar{U}$ und $\Delta U$ sind also Wechselspannungen mit einer Grundfrequenz

$$f_W = \tfrac{1}{T_W} = \tfrac{1}{2T_A}.$$

ohne jede Gleichkomponente.

Von Nullverstärkern in Regelkreisen werden grundsätzlich folgende Eigenschaften verlangt:

a) Ein großer Verstärkungsfaktor im Übertragungsbereich der Regelabweichung;

b) ein kleinstmöglicher Nullpunktsfehler bei der Verstärkung der Regelabweichung;

c) im Interesse hoher Selektivität und Störgrößenunterdrückung ein kleinstmöglicher Verstärkungsfaktor außerhalb des Übertragungsbereiches der Regelabweichung.

Nicht verlangt werden dagegen

d) eine lineare Aussteuerungskennlinie;

e) ein phasenlinearer Frequenzgang und

f) eine besondere Stabilität des Verstärkungsfaktors.

Mit der Eigenschaft c) wird ein Nullverstärker, wie er bei der bekannten Schaltung eingesetzt war, im Übertragungsbereich $f < f_W$ einen zu niedrigeren Frequenzen hin möglichst steil abfallenden Amplitudengang aufweisen und insbesondere die Frequenz 0, also Gleichspannungssignale, nicht übertragen (Hochpaß-Charakteristik).

Das hat aber bei dem Abgleichprinzip, nach dem hier gearbeitet wird, nämlich dem dauermodulierten Umschalten, zu Folge, daß bei den resultierenden Rechtecksignalen $\Delta U$ Dachschrägen auftreten, die ihrerseits zu einer Nichtlinearität der Anzeigekennlinie führen, wie weiter unten noch näher erläutert wird.

Ein Fehlen der Eigenschaft e), also ein nicht phasenlinearer Frequenzgang im Übertragungsbereich $f \geq f_W$ des Nullverstärkers, hat Laufzeitverzerrungen bei der Verstärkung des Differenzsignals $\Delta U$ zur Folge. Diese können bei der phasenselektiven Gleichrichtung des verstärkten Differenzsignals $\Delta U$ durch den getakteten Umschalter S4 zur Erzeugung fehlerhafter Gleichspannungskomponenten führen, die nicht der Regelabweichung $\Delta \bar{U}$ proportional sind und Nullpunktsfehler darstellen.

Fehlt die Eigenschaft d), eine lineare Aussteuerungskennlinie, auch wenn diese drehsymmetrisch (ohne geradzahlige Krümmungsglieder) ist, werden positive und negative Amplitudenabschnitte im Spannungsverlauf von $\Delta U$ mit unterschiedlichem Gewicht bewertet. Das führt zu Fehlern bei der Bildung des arithmetischen Mittelwertes $\Delta \bar{U}$ des Differenzsignals, die sich ebenfalls als Nullpunktsfehler bemerkbar machen. Diese schwanken dazu noch in ihrer Größe, wenn, wie bei einem üblichen Nullverstärker, auch die Eigenschaft f), besondere Stabilität des Verstärkungsfaktors, fehlt. Da die Fehler bei der Mittelwertbildung auch noch vom Einschaltverhältnis $a = t_e/T_A$ abhängig sind, wirken sich von a abhängige Nullpunktsfehler zusätzlich als Linearitätsfehler auf die Anzeigekennlinie aus.

Die durch die Eigenschaften des Nullverstärkers NV verursachten Mängel werden noch verschärft durch die für den Speisestrom IS'' für den dauermoduliert zu- und abzuschaltenden Kompensationswiderstand R vorgesehene Potentialtrennung gegenüber den Speiseströmen IS' für die Meßgrößenaufnehmer durch Stromwandler Tr.

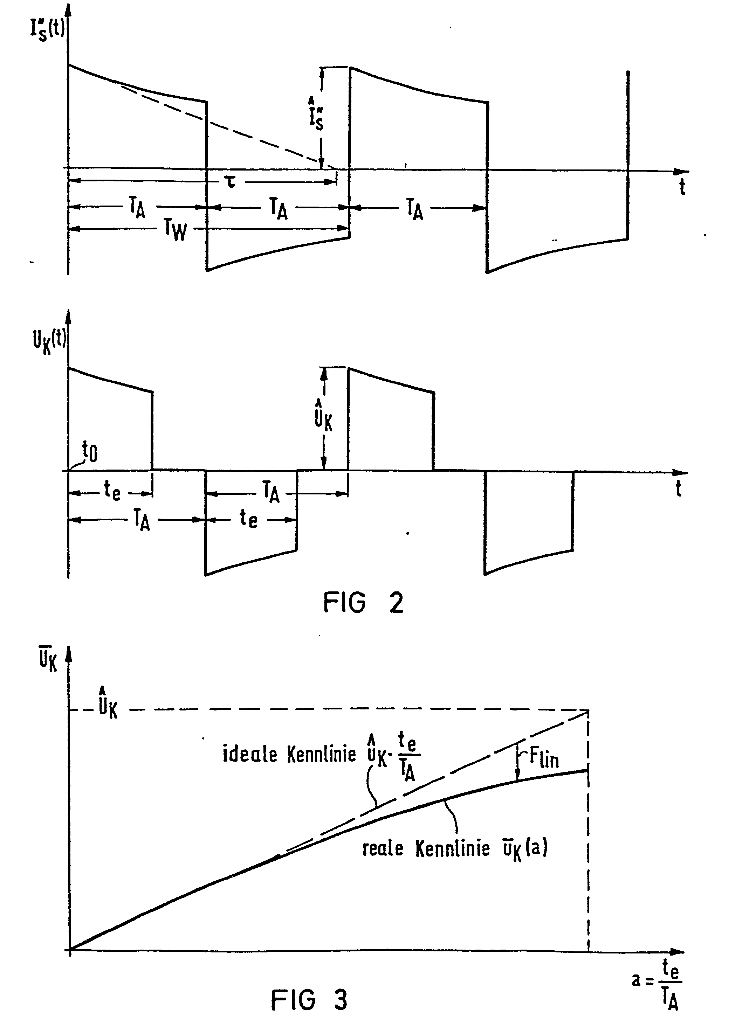

Wegen der unvermeidbaren Streuinduktivitäten und nur endlich groß dimensionierbaren Hauptinduktivitäten dieser Strömwandler sowie dem endlich kleinen Innenwiderstand der Gleichspannungsquelle, die den Schalter S1 speist, können die sekundären Speisewechselströme IS' und IS'' keine ideale Rechteckform aufweisen. Sie zeigen vielmehr Dachschrägen in Form von e-Funktionen, wie dies in einer Figur 2 der Zeichnung dargestellt ist. Für den Speisestrom des Kompensationswiderstandes R gilt:

$$IS''(t) = \widehat{IS}''\, e^{-\frac{t}{\tau}}$$

wobei $\tau$ eine Zeitkonstante ist, die durch die Werte der Streu- und Hauptinduktivität des Stromwandlers Tr2 den Innenwiderstand der Gleichstromquelle und den Kompensationswiderstand bestimmt ist. In Figur 2 bedeutet $T_A$ die Schaltdauer einer Polarität des Polumschalters S1, woraus sich die Periodendauer $T_W = 2 \cdot T_A$ für die Speisewechselströme IS' und IS'' ergibt.

Das bedeutet, daß die Kompensatorschaltung eine höheren Genauigkeitsanforderungen nicht genügende Nichtlinearität ihrer Anzeigekennlinie aufweist, weil entsprechend einer Figur 3 der arithmetische Mittelwert $\bar{Uk}$ der Kompensationsspannung Uk über jeweils eine Einschaltdauer $T_A$ nicht, wie vom Prinzip der Impulsdauermodulation zu fordern, dem Abgleichfaktor $a = t_e/T_A$ als dem Quotienten aus der Einschaltzeit $t_e$ des Kompensationswiderstandes R und der Schaltdauer $T_A$ proportional ist.

Vielmehr ist

3

$$\overline{Uk}\,(a) = \frac{1}{T_A} \int_{t_0\,=\,0}^{t_0\,+\,t_e} \hat{Uk}\; e^{-\frac{t}{\tau}}\, dt = -\hat{Uk}\cdot\frac{\tau}{T_A}\cdot e^{-\frac{t}{\tau}}\;\Bigg|_0^{t_e}$$

$$\text{mit } \hat{Uk} = IS'' \cdot R$$

Aus dem bestimmten Integral wird

$$\overline{Uk}\,(a) = \hat{Uk}\cdot\frac{\tau}{T_A}\left[1 - e^{-a\cdot\frac{T_A}{\tau}}\right]$$

und nach einer Reihenentwicklung von

$$\frac{\tau}{T_A}\left[1 - e^{-a\frac{T_A}{\tau}}\right]$$

mit $a = t_e/T_A$ wird daraus

$$\overline{Uk}\,(a) = \hat{Uk}\cdot a\cdot\left[1 - \frac{1}{2}\frac{t_e}{\tau} + \frac{1}{6}\left(\frac{t_e}{\tau}\right)^2 - \frac{1}{24}\left(\frac{t_e}{\tau}\right)^3 + \ldots\right]$$

Wie Figur 3 zeigt, wächst nach dem obenstehenden Reihenausdruck die Kompensationsspannung $\bar{Uk}$ nicht proportional zu $a = t_e/T_A$, sondern unterlinear mit einem Linearitätsfehler $F_{Lin}$, der um so größer ist, je kleiner die Zeitkonstante $\tau$ der Dachschräge im Vergleich zur Schaltdauer $T_A$ ist.

Andererseits wird der arithmetische Mittelwert $\bar{Um}$ aus der Summe Um der Ausgangsspannungen $Um_\gamma$ aller n Meßgrößenaufnehmer $DMS_\gamma$ von der bekannten Kompensatorschaltung stets über die volle Schaltdauer $T_A$ gebildet, also

$$\overline{Um} = \frac{1}{T_A}\int_0^{T_A}\sum_{\gamma=1}^{n}\hat{Um}_\gamma\; e^{-\frac{t}{\tau_\gamma}}\, dt = -\frac{1}{T_A}\sum\tau_\gamma\cdot\hat{Um}_\gamma\cdot e^{-\frac{t}{\tau_\gamma}}\;\Bigg|_0^{T_A}$$

Damit aber wird

4

$$\overline{Um} = \sum_{1}^{n} \frac{\tau_\gamma}{T_A} \cdot \widehat{Um}_\gamma \cdot \left[ 1 - e^{-\frac{T_A}{\tau_\gamma}} \right] = \sum_{1}^{n} k_\gamma \cdot \widehat{Um}_\gamma$$

mit

$$k_\gamma = \tau_\gamma / T_A \left[ 1 - e^{-\frac{T_A}{\tau_\gamma}} \right]$$

und

$$\widehat{Um}_\gamma = c_\gamma \cdot G_\gamma \cdot \widehat{IS}_\gamma'$$

wobei $c_\nu$ eine Aufnehmerempfindlichkeitskonstante bedeutet. Somit ist der Mittelwert $\overline{Um}$ wegen der rein ohmschen Netzwerke in den Aufnehmern $DMS_\nu$ trotz der durch $\tau_\nu$ verkörperten Dachschrägen der Einzelsignale $Um_\nu$ der Summe der in jedem Augenblick auf die n Aufnehmer $DMS_\nu$ einwirkenden Meßgrößen $G_\nu$ streng linear proportional.

Ein dem Einschaltverhältnis $a = t_e/T_A$ proportionaler Anzeigewert A der bekannten Kompensatorschaltung wird über die Abgleichbedingung

$\overline{Uk}(a) = \overline{Um}(\Sigma G_\nu)$

gewonnen. Wegen der Unterlinearität von $\overline{Uk}$ muß die bekannte Kompensatorschaltung deshalb als Ganzes eine überlineare Anzeigekennlinie aufweisen.

Der Erfindung lag die Aufgabe zugrunde, die eingangs beschriebene Auswerteschaltung für passive Meßwertaufnehmer so zu verbessern, daß sie eine lineare Anzeigekennlinie erhält. Dabei sollen ihre Vorzüge bezüglich Unempfindlichkeit gegen Thermo- und Kontaktspannungen der Aufnehmer, des Kompensationsgrößengenerators und der Eingangsinstallation sowie gegen Nulldriften der Verstärkung erhalten bleiben.

Die Lösung dieser Aufgabe erfolgt gemäß der Erfindung durch die in den kennzeichnenden Merkmalen des Anspruchs 1 beschriebenen Maßnahmen.

Die erste Maßnahme betrifft die Verlagerung des bei der bekannten Schaltung nach Figur 1 vorgesehenen Nullverstärkers NV hinter den Tiefpaß TP unter Einsatz eines direkt gekoppelten Vorverstärkers am bisherigen Platz des Nullverstärkers. Dieser Vorverstärker besteht zweckmäßig aus einem galvanisch an einen die Abgleichdifferenzspannung bzw. einen Abgleichdifferenzstrom abgebenden Ausgang des Netzwerkes aus Aufnehmer- und Kompensationswiderständen sowie gegebenenfalls zugehöriger Kopplungselemente angeschlossenen Operationsverstärker. Er hat einen bei der Frequenz 0 (Gleichkomponenten durchlässig) beginnenden phasenlinearen Frequenzgang, der breitbandig über die Umpolfrequenz $f_W = \frac{1}{2T_A}$ hinaus verstärkt. Sein Amplitudengang braucht dabei nicht besonders eben zu sein. Die Verstärkung kann in bezüglich der Taktzeit $T_A$ langen Zeiträumen in weiteren Grenzen ohne Beeinflussung der Anzeigegenauigkeit schwanken. Seine Aussteuerkennlinie muß dagegen für jede Frequenz im Übertragungsbereich streng linear sein. Bevorzugt hat der Vorverstärker nur eine relativ geringe Verstärkung, um sicherzustellen, daß er von kapazitiven oder induktiven Störeinstreuungen in die Eingangsverdrahtung oder durch eigene Rauschkomponenten sowie Nulldriften im Abgleichzustand der Auswerteeinrichtung nicht über seine Aussteuergrenzen hinweg betrieben wird.

Eine weitere Maßnahme betrifft die direkte Kopplung des den umschaltbaren Widerstand durchfließenden Stromes an den Polumschalter der Gleichstromquelle. Sie sorgt dafür, daß dieser Strom strenge Rechteckform und keine Linearitätsfehler verursachenden Dachschrägen mehr aufweist.

Wegen der durch diese Maßnahmen erzielten Übertragungseigenschaften des Vorverstärkers wird das Abgleichdifferenzsignal so verstärkt, daß weder aufgrund von Laufzeitverzerrungen noch wegen nichtlinearer

5

Aussteuerungen bei der nachfolgenden phasenempfindlichen Gleichrichtung den richtigen Anzeigewert verfälschende Gleichkomponenten als Nullpunktsfehler entstehen können.

Zweckmäßig weist der phasenempfindliche Gleichrichter eine streng lineare Kennlinie auf, die exakt durch den Nullpunkt verläuft.

Die beachtlichen Vorteile des Einsatzes einer derartigen Vorverstärkung mit nachfolgender Gleichrichtung bestehen darin, daß sämtliche störenden Gleichkomponenten aus der Eingangsschaltung, also die Nulldriften des Vorverstärkers, Thermospannungen und Kontaktpotentiale der Aufnehmer des schaltgesteuerten Kompensationswiderstandsnetzwerkes sowie der Zuleitungen zum Vorverstärker im phasenempfindlichen Gleichrichter in Rechteckspannungen der Grundfrequenz $f_W$ des Wechselrichters umgeformt werden. Sie können wegen deren großen Abstandes von der Frequenz 0 leicht in nachgeschalteten Tiefpässen wirkungsvoll ausgesiebt werden.

Die Rauschkomponenten erfahren beim Demodulationsvorgang demgegenüber alle eine Frequenzverschiebung um $\pm$ $f_W$ der Wechselrichterfrequenz $f_W$. Dadurch werden die sehr störenden niederfrequenten Rauschkomponenten einfacher Halbleiterverstärkereingangsstufen, das sogenannte Popcorn- oder $\frac{1}{f}$-Rauschen, in die unmittelbare Nachbarschaft der Wechselrichterfrequenz $f_W$ verschoben und können ebenso wirkungsvoll von den nachfolgenden Tiefpässen unterdrückt werden. Deshalb stellt nur noch das sogenannte weiße Rauschen die natürliche Auflösungsgrenze der Auswerteschaltung nach der Erfindung dar.

Die synchrone Steuerung des phasenempfindlichen Gleichrichters mit dem Polumschalter sorgt dafür, daß eine höheren Genauigkeitsansprüchen genügende Unterdrückung der erwähnten · störenden Gleichkomponenten im verstärkten Abgleichdifferenzsignal erzielt wird, weil damit auch der selektive Gleichrichter in strenger Zeitsymmetrie gesteuert wird.

Der Generator für die hochfrequente Impulsfolge ist zweckmäßig quarzstabilisiert.

Die Symmetrie zweier Zweige des phasenempfindlichen Gleichrichters gegenüber Masse wird vorteilhafterweise durch ein Potentiometer justierbar gemacht.

Mit Vorteil sind auch die Meßgrößenaufnehmer-Brückenschaltungen neben dem umschaltbaren Widerstand mit dem Polumschalter galvanisch gekoppelt.

Eine ähnlich günstige Wirkung wird erzielt, wenn die Meßgrößenaufnehmer-Brückenschaltung und/oder der umschaltbare Widerstand über Operationsverstärker oder Optokoppler mit dem Polumschalter gekoppelt sind.

Bei einem bevorzugten Ausführungsbeispiel der Erfindung ist die direkte Kopplung einer Meßgrößenaufnehmer-Brückenschaltung und eines umschaltbaren Widerstandes dadurch verwirklicht, daß die Brückenschaltung mit ihrer Speisediagonalen galvanisch an den Polumschalter gekoppelt und an einem ihrer Diagonalpunkte aufgetrennt ist. In die Trennstelle ist der umschaltbare Widerstand eingefügt, wobei der Umschaltkontaktarm des Umschalters den Diagonalpunkt an der Trennstelle ersetzt. Die Eingangsklemmen des Vorverstärkers liegen an der Meßdiagonalen der Meßgrößenaufnehmer-Brückenschaltung.

Bei einem anderen Ausführungsbeispiel ist die Speisediagonale der Meßgrößenaufnehmer-Brückenschaltung galvanisch mit dem Polumschalter gekoppelt. Der umschaltbare Widerstand ist zwischen den Ausgang eines mit seinen Eingangsklemmen am Polumschalter liegenden ersten Operationsverstärkers und Masse geschaltet. Die Meßdiagonale der Meßgrößenaufnehmer-Brückenschaltung liegt dabei an den Eingangsklemmen eines zweiten Operationsverstärkers, dessen Ausgang über einen Widerstand mit Masse verbunden ist sowie an einer Eingangsklemme des Vorverstärkers liegt. Der Vorverstärker ist mit seiner anderen Eingangsklemme an den Umschaltkontaktarm des Umschalters angeschlossen, der in der einen Stellung am Ausgang des ersten Operationsverstärkers und in der anderen Stellung an Masse liegt. Bei einem weiteren Ausführungsbeispiel der Erfindung ist die Speisediagonale der Meßgrößenaufnehmer-Brückenschaltung galvanisch mit dem Polumschalter gekoppelt. Der umschaltbare Widerstand ist über den Umschalter zwischen den Ausgang eines mit seinen Eingangsklemmen am Polumschalter liegenden ersten Operationsverstärkers und Masse geschaltet. Die Meßdiagonale der Meßgrößenaufnehmer-Brückenschaltung liegt an den Eingangsklemmen eines zweiten Operationsverstärkers, dessen Ausgang über einen Widerstand an derjenigen Eingangsklemme des Vorverstärkers liegt, die mit einem der Umschaltkontakte des Umschalters verbunden ist. Die andere Eingangsklemme des Vorverstärkers liegt an Masse.

Das Merkmal der direkten Kopplung ist bei einem anderen Ausführungsbeispiel der Erfindung so verwirklicht, daß der Meßgrößenaufnehmer-Brückenschaltung speise- und meßdiagonalseitig eine zweite Widerstandsbrückenschaltung parallelgeschaltet ist, wobei die zweite Widerstandsbrückenschaltung an einem Meßdiagonalpunkt aufgetrennt und der umschaltbare Widerstand in die Trennstelle eingefügt ist. Die Eingangsklemmen des Vorverstärkers sind dabei an die parallelgeschalteten Meßdiagonalen der beiden Widerstandsbrückenschaltungen angeschlossen. Anstelle der zweiten Widerstandsbrückenschaltung kann auch eine Halbbrückenschaltung treten, deren Zweige den umschaltbaren Widerstand einschließen.

Noch ein anderes Ausführungsbeispiel der Erfindung weist eine der Meßgrößenaufnehmer-Brückenschaltungspeise- und meßdiagonalseitig parallelgeschaltete zweite Widerstandsbrücke auf, die an einem Speisediagonalpunkt aufgetrennt ist, wobei die Trennstelle von zwei Kontakten des Umschalters besetzt ist. Der Umschaltkontaktarm des Umschalters liegt dabei an einem der Speisediagonalpunkte der Meßgrößenaufnehmer-Brückenschaltung. Die Eingangsklemmen des Vorverstärkers sind an die parallelgeschalteten Meßdiagonalen der beiden Widerstandsbrückenschaltungen angeschlossen.

Ein letztes Ausführungsbeispiel der Erfindung weist einen Umschaltwiderstand auf, der mit Hilfe des Umschalters abwechselnd zwei zu einem Diagonalpunkt symmetrisch liegenden Widerständen der Meßgrößenaufnehmer-Brückenschaltung parallelschaltbar ist, wobei die Eingangsklemmen des Vorverstärkers an der Meßdiagonalen liegen.

Die Dauer einer Abgleichperiode $T_A$ steht zur Dauer-$T_W$ der Wechselrichter- und Gleichrichtertaktzeit im Verhältnis ganzer Zahlen (z. B. 1: 2; 2: 3; 3: 5 etc.).

Neben den zur Erklärung der Mängel des Standes der Technik dienenden, schon besprochenen Figuren 1 bis 3 sind verschiedene Ausführungsbeispiele der Erfindung in weiteren zehn Figuren dargestellt.

Figur 4 enthält ein Ausführungsbeispiel der Erfindung, bei dem eine Verstimmungskompensation angewendet ist.

In Figur 5 sind in Diagrammen a, b und c die an charakteristischen Schaltpunkten der Schaltung nach Figur 4 anfallenden Spannungsverläufe dargestellt.

Figur 6 stellt ein abgeändertes Detail der Schaltung nach Figur 4 dar.

In den Figuren 7 bis 13 sind jeweils verschiedene Ausführungen der direkten Ankopplung des Aufnehmer- und Kompensationsnetzwerkes an den Wechselrichter oder Umpolschalter dargestellt.

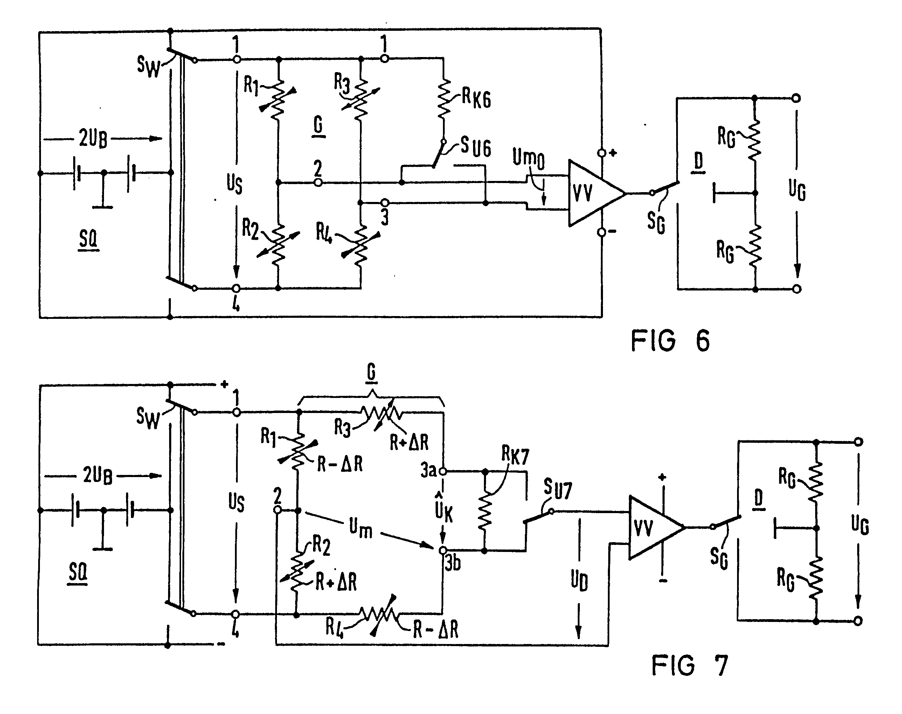

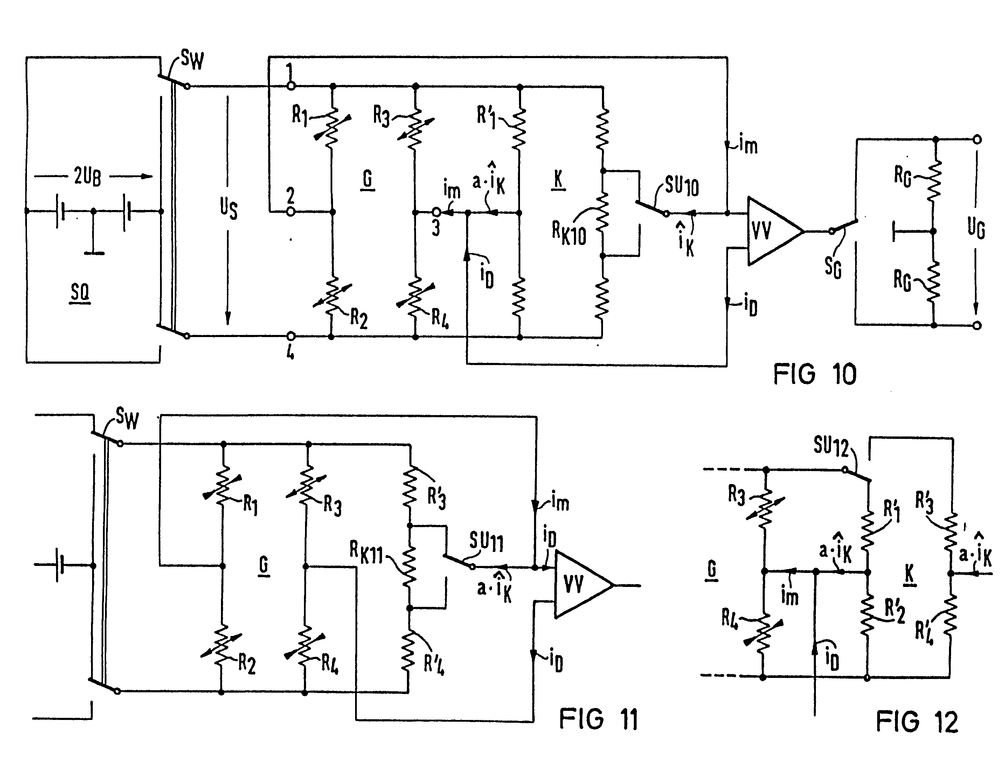

Die Schaltungen nach den Figuren 7 bis 9 folgen dem Prinzip der Spannungskompensation; bei den Schaltungen nach den Figuren 10 bis 13 wird dagegen das Prinzip der Stromkompensation verwendet.

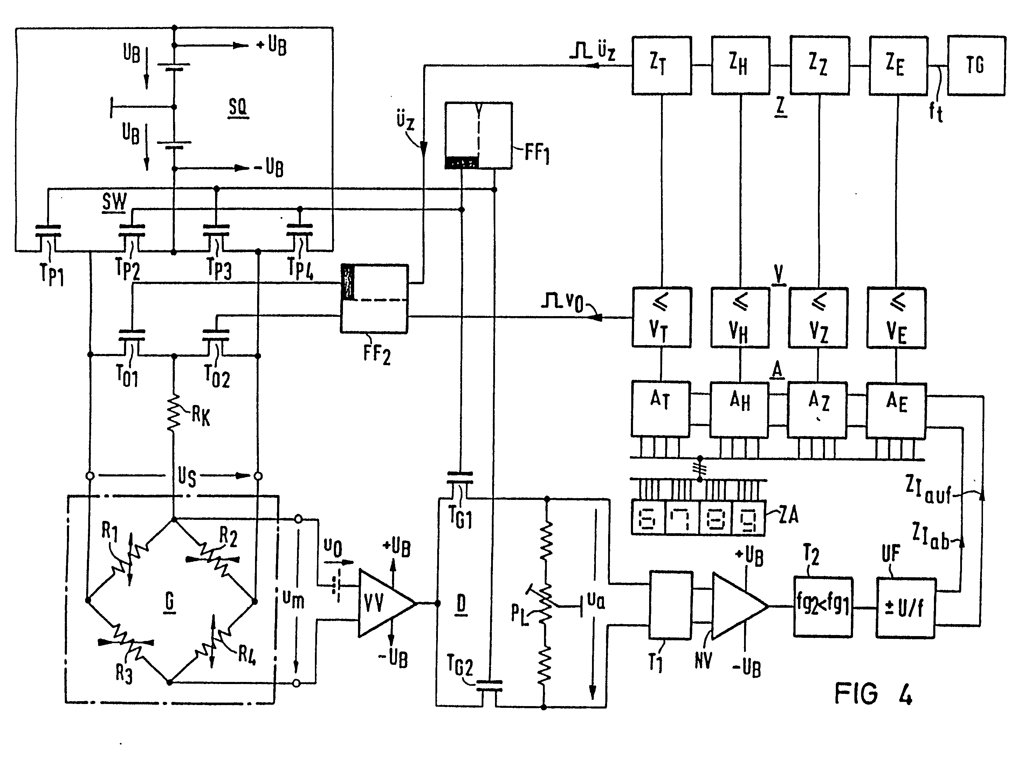

In Figur 4 ist eine vorzugsweise erdsymmetrische Spannungsquelle SQ über Schaltstrecken $T_{P1}$... $T_{P4}$, die einen-Polumschalter oder Wechselrichter SW bilden, mit einem Meßgrößenaufnehmer G, der als Aufnehmermeßbrücke mit vier veränderlichen Widerständen $R_1$... $R_4$ dargestellt ist, verbunden. Über Schaltstrecken $T_{01}$ und $T_{02}$ ist den Meßbrückenwiderständen $R_1$ bzw. $R_2$ abwechselnd ein Abgleichwiderstand $R_K$ parallelzuschalten. Die Schaltstrecken $T_{P1}$... $T_{P4}$ des Polumschalters oder Wechselrichters werden durch Ausgangssignale eines Flip-Flops $FF_1$ gesteuert. Ein dynamischer Eingang des Flip-Flops $FF_1$ liegt an einem Ausgang für ein Überlaufsignal $\ddot{u}_z$ eines Zählers Z, der von Taktimpulsen eines Taktgenerators TG beaufschlagt ist. Bitausgänge des Taktimpulszählers Z sind mit entsprechenden Eingängen eines digitalen Vergleichers V verbunden, dessen Vergleichsbiteingänge an Bitausgängen eines Anzeigezählers A liegen. Ein bei Gleichheit der Zählerinhalte der Zähler Z und A signalführender Ausgang des Vergleichers V ist mit einem der Steuereingänge eines zweiten Flip-Flops $FF_2$ verbunden. Der andere Steuereingang des Flip Flops $FF_2$ liegt am das Überlaufsignal $\ddot{u}_z$ abgebenden Ausgang des Zählers Z. Die beiden Ausgänge des Flip-Flops $FF_2$ sind jeweils mit einem Steuereingang einer der Schaltstrecken $T_{01}$ bzw. $T_{02}$ verbunden.

Die Meßdiagonale des Aufnehmers G liegt an Eingängen eines Vorverstärkers VV. Der Ausgang dieses Vorverstärkers VV ist an den Eingang eines phasenempfindlichen Gleichrichters D angeschlossen, der im wesentlichen aus den Schaltstrecken $T_{G1}$ und $T_{G2}$ besteht. Steuereingänge der Schaltstrecken $T_{G1}$ und $T_{G2}$ sind an zwei gegenseitig invertierte Signale führende Ausgänge des Flip-Flops $FF_1$ angeschlossen, die gleichzeitig die Schaltstrecken des Polumschalters oder Wechselrichters SW steuern. Die beiden Zweige des phasenempfindlichen Gleichrichters D sind über ein beide Zweige verbindendes Potentiometer PL zentrierbar. Der Ausgang des phasenempfindlichen Gleichrichters D liegt über ein erstes Tiefpaßglied $T_1$ an den Eingängen eines als Gleichspannungs-Nullverstärker wirkenden Nachverstärkers NV, dessen Ausgang über ein zweites Tiefpaßglied $T_2$ mit dem Eingang eines Spannungs-Frequenz-Umformers UF verbunden ist. Je nach Polarität der Eingangsspannung des Spannungs-Frequenz-Umformers wird einer von zwei Ausgängen des Spannungs-Frequenz-Umformers signalführend. Die beiden Ausgänge sind mit entsprechenden Eingängen für Vorwärts- und Rückwärtszählung des Anzeigezählers A verbunden. Bitausgänge des Anzeigezählers A liegen an entsprechenden Eingängen einer Ziffernanzeige ZA.

Im folgenden wird die Wirkungsweise der Schaltung beschrieben.

Mit Hilfe der Schalterstrecken $T_{P1}$... $T_{P4}$ des Polumschalters oder Wechselrichters SW wird aus der erdsymmetrischen, nur gegen kurzfristige Spannungsschwankungen stabilisierten Versorgungsspannung $\pm U_B$ der Spannungsquelle SQ für die Elektronikbausteine der Auswerteschaltung eine rechteckförmige Speisespannung $U_S$ mit dem exakten Taktverhältnis 1 : 1 für die Speisung des Meßgrößenaufnehmers G abgeleitet. Diese hat bei Vernachlässigung der Spannungsabfälle über die Wechselrichterschaltstrecken $T_{P1}$... $T_{P4}$ eine Amplitude von 2 $U_B$ und eine Periodendauer von $T_W = 2 T_A$. Dabei ist $T_A$ die Zeit, die benötigt wird, um den Taktimpulszähler Z durch die von dem kurzzeitstabilen Taktgenerator TG gelieferten Impulse mit der Folgefrequenz $f_t$ von 0 auf seinen Maximalwert $Z_{max}$ hochzuzählen. Der nach der Vollzählung des Zählers Z von diesem gelieferte Überlaufimpuls $\ddot{u}_z$ setzt einmal den Taktimpulszähler Z selber wieder auf "0" und wirkt gleichzeitig auf den dynamischen Eingang des Flip-Flops $FF_1$ ein, das dadurch jeweils nach dem Ablauf der Zeit $T_A$ seinen Schaltzustand ändert. Dadurch werden jeweils wechselweise für eine n-te Taktzeit $T_{An}$ die Schaltstrecken $T_{P1}$ und $T_{P3}$ und für die darauffolgende Taktzeit $T_{An+1}$ die Schaltstrecken $T_{P2}$ und $T_{P4}$ des Wechselrichters SW oder Polumschalters auf Durchlaß gesteuert, so daß an der Speisediagonalen des Meßwertaufnehmers G eine Rechteckspannung $U_S$ mit dem geforderten exakten Taktverhältnis 1 : 1 zur Verfügung steht. Phasenstarr und streng synchron mit den Schaltstrecken $T_{P1}$ ... $T_{P4}$ des Wechselrichters werden auch von der jeweiligen Stellung des Flip-Flops $FF_1$ wechselweise für die Dauer der Zeit $T_A$ die Schaltstrecken $T_{G1}$ und $T_{G2}$ des phasenempfindlichen Gleichrichters D auf Durchlaß gesteuert. Der phasenempfindliche Gleichrichter D demoduliert dabei die Ausgangsspannung des Vorverstärkers VV.

Der Vorverstärker VV ist mit der Meßdiagonalen des Meßwertaufnehmers G gleichstromgekoppelt und arbeitet als phasenlinearer Breitbandverstärker mit hochlinearer Aussteuerkennlinie ab einer Frequenz 0. Er verstärkt deshalb die Aufnehmermeßspannung $u_m$, die neben den aus Thermospannungen und Kontaktpotentialen bestehenden unerwünschten Störgleichanteilen ausschließlich Wechselkomponenten aufweist, deren Grundfrequenz

7

$$f_w = \frac{1}{T_w} = \frac{1}{2T_s}$$

ist und im übrigen aus deren Oberwellen besteht. Der Vorverstärker VV verstärkt weiterhin unerwünschte Gleichkomponenten, die aus Strom- und Spannungsnulldriften des Vorverstärkers VV selbst resultieren. Die Wirkung dieser Nulldriften ist zusammen mit den Thermo- und Kontaktspannungen des Aufnehmer- und Kompensationsnetzwerkes in einer Ersatzspannung $u_0$ zusammengefaßt. Dazu verstärkt der Vorverstärker VV auch sämtliche Rauschspannungsanteile, die hauptsächlich in der Eingangsstufe des Vorverstärkers VV, aber auch als weißes Widerstandsrauschen im Aufnehmer- und Kompensationsnetzwerk erzeugt werden.

Sämtliche störenden Gleichkomponenten werden im streng symmetrisch geschalteten, hochlinearen phasenempfindlichen Gleichrichter D in Rechteckspannungen der Grundfrequenz $f_w$ umgeformt, die wegen ihres großen Abstandes von der Frequenz 0 leicht in den nachgeschalteten Tiefpässen $T_1$ und $T_2$ trotz deren relativ hoher Grenzfrequenz wirkungsvoll ausgesiebt werden können.

Ebenso vorteilhaft ist ein anderes Ergebnis der Wirkungsweise der neuen Schaltung, das darin besteht, daß die Rauschkomponenten des Ausgangssignales des Vorverstärkers VV beim Demodulationsvorgang sämtlich eine Frequenzverschiebung um $\pm f_w$ erfahren. Dadurch werden die sonst sehr störenden niederfrequenten Rauschkomponenten, insbesondere einfacher Halbleiterverstärkereingangsstufen, - das sogenannte Popcorn- oder $\frac{1}{f}$-Rauschen - in die unmittelbare Nachbarschaft der Wechselrichterfrequenz $f_w$ verschoben und können daher ebenfalls wirkungsvoll von den nachfolgenden Tiefpässen $T_1$ und $T_2$ unterdrückt werden. Die um Größenordnungen kleineren Rauschanteile des sogenannten weißen Rauschens werden nicht unterdrückt. Nur diese Art von Rauschen stellt deshalb die natürliche Auflösungsgrenze der neuen Auswerteschaltung dar, der man sich auch schon mit sehr billigen Operationsverstärkern praktisch beliebig nähern kann. Beispielsweise liegt diese Grenze bei 10 bis 30 nV, je nach Innenwiderstand des Meßgrößenaufnehmers und Wahl der Tiefpaßgrenzfrequenz.

Von einer meßgrößenabhängigen Verstimmung

$$-\frac{\Delta B}{B} = b \frac{\Delta R_{max}}{R}$$

des Meßgrößenaufnehmers herrührende Meßspannungskomponenten in $u_m$ haben einen rechteckförmigen Spannungsverlauf mit einer Amplitude von

$$b \hat{u}_m = \frac{b \cdot \Delta R_{max}}{R} \cdot U_S,$$

die wegen des Aufbaues des Aufnehmer- und Kompensationsnetzwerkes aus rein ohmschen Widerständen exakt in Phase mit $U_S$ ist. Hierin ist $\frac{\Delta R_{max}}{R}$ die Verstimmungsänderung der Aufnehmermeßbrücke, welche die Meßgröße bei Erreichen ihres Meßbereichendwertes an dieser hervorruft. Der Faktor b gibt demnach den Grad der Teilaussteuerung dieses Meßbereiches an. Er kann somit Werte zwischen 0 und 1 annehmen. Die Rechteckspannung b . $\hat{u}_m$ wird nach Vorverstärkung durch VV vom phasenempfindlichen Gleichrichter D vorzeichenrichtig in eine proportionale Gleichspannung umgeformt, die den Tiefpaß $T_1$ und nach Nachverstärkung durch den Nachverstärker NV ungehindert auch den Tiefpaß $T_2$ passieren kann und unter vorzeichenrichtiger Bewertung im nachfolgenden Spannungs-Frequenz-Umformer UF in eine Impulsfolge

$$z_{I_{auf}} \quad \text{bzw.} \quad z_{I_{ab}}$$

mit einer der jeweiligen Restverstimmung des Meßgrößenaufnehmers proportionalen Folgefrequenz umgeformt wird.

Die hierbei erzeugten Zählerimpulse

$$z_{I_{auf}} \quad \text{bzw.} \quad z_{I_{ab}}$$

dienen dazu, den augenblicklichen Zählerinhalt des Anzeigezählers A mit seinen - im Ausführungsbeispiel vier-Zähldekaden $A_T$, $A_H$, $A_Z$ und $A_E$ im Sinne einer Annäherung auf den durch b vorgegebenen Abgleichzustand der Meßschaltung in Aufwärts- bzw. Abwärtsrichtung zu verändern.

Es wurde schon erwähnt, daß es für die Linearität und Langzeitstabilität der Anzeigekennlinie der Auswerteschaltung von entscheidender Bedeutung ist, daß der Vorverstärker VV eine Aussteuerungskennlinie aufweist, die zumindest im Frequenzbereich

$$f_w - f_{dyn_{max}} \quad \text{bis} \quad f_w + f_{dyn_{max}}$$

streng linear, jedoch nicht langzeitstabil sein muß, und daß der phasenempfindliche Gleichrichter D streng symmetrisch und ebenfalls mit einer hochlinearen Kennlinie arbeitet. Deshalb ist es zweckmäßig, im phasenempfindlichen Gleichrichter D mit Hilfe eines Trimm-Potentiometers PL eine Möglichkeit zur Feinjustage dieser Symmetrie vorzusehen. Umgekehrt ist es möglich, mit Hilfe dieser Justiermöglichkeit auch bewußt eine Unsymmetrie einzuführen, wenn die Aufnehmerkennlinie geradzahlige Krümmungsglieder aufweisen sollte. Im Zusammenwirken von Meßaufnehmer und Auswerteschaltung kann auf diese Weise ein sehr einfacher, aber hochwirksamer Linearitätsabgleich bewirkt werden. Ein derartiger Linearitätsabgleich ist insbesondere empfehlenswert, wenn die Auswerteschaltung über die in Figur 4 dargestellten vier Zähldekaden hinaus eine noch größere digitale Meßwertauflösung durch eine größere Anzahl von Zähldekaden aufweist.

Bei den heute vorhandenen Möglichkeiten der digitalen Schaltungstechnik kann eine Auflösung zwischen $10^5$ bis $10^6$ erreicht werden, so daß der Einsatz von fünf bis sechs Zähldekaden sinnvoll wird.

Für den Fall einer erhöhten Auflösung ist es auch sinnvoll, eine in der Figur 4 nicht dargestellte Ausführungsvariante anzuwenden, die den Einfluß von Laufzeitschwankungen des Vorverstärkers VV sowie der endlichen Umschaltdauer und der Umladungseffekte der Umschaltstrecken für den Abgleichwiderstand $R_K$ zu eliminieren gestattet.

Dazu wird durch eine entsprechend ausgelegte Steuerung nach dem Auftreten eines Überlaufsignales $\ddot{u}_z$ durch Sperren der zuletzt leitenden Wechselrichterschaltstrecken $T_{P1}$, $T_{P3}$ bzw. $T_{P2}$, $T_{P4}$ die Meßaufnehmerspeisespannung $U_S$ für einen kurzen Zeitraum $t_{\ddot{u}1}$ auf "0" gesetzt. In diesem spannungsfreien Zustand erfolgt nach Ablauf von $t_{\ddot{u}1}$ die Umschaltung des Widerstandes $R_K$ durch die Schaltstrecke $T_{01}$ bzw. $T_{02}$ sowie das Umsteuern des phasenempfindlichen Gleichrichters D.

Erst nach dem Ablauf einer weiteren kurzen Zeitspanne $t_{\ddot{u}2}$ wird dann die Speisespannung $U_S$ wieder über die komplementären Wechselrichterschaltstrecken mit umgekehrter Polarität eingeschaltet.

Es wird noch darauf hingewiesen, daß die beim in der Figur 4 dargestellten Ausführungsbeispiel durch einzelne Schaltelemente gelösten Zähl-, Vergleichs- und Steueraufgaben gegebenenfalls von einem schon vorhandenen und für andere Aufgaben benötigten Mikroprozessor gelöst werden können. Dadurch läßt sich der aufgabenspezifische Teil der Auswerteschaltung erheblich reduzieren. Damit ergibt sich eine Möglichkeit, eine sinnvolle Integration in einem sehr flexibel einsetzbaren Kundenschaltkreis durchzuführen.

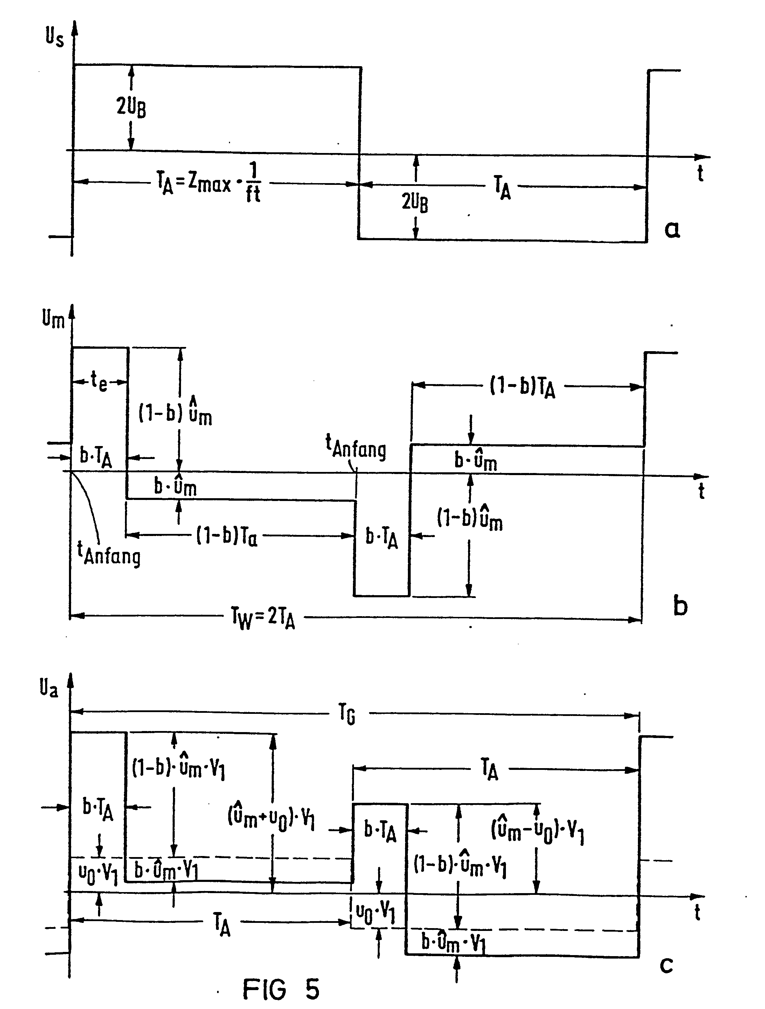

Im Diagramm a der Figur 5 ist der Verlauf der Speisespannung $U_S$ des Meßaufnehmers längs der Zeitachse t dargestellt. Die Amplitude der rechteckförmigen Wechselspannung, welche durch Umpolung erzeugt wird, beträgt 2 $U_B$. Die Periode der Wechselspannung ist 2 $T_A$. Die Halbperiode $T_A$ ist das Produkt aus dem maximalen Inhalt $Z_{max}$ des Zählers Z, dividiert durch die Folgefrequenz $f_t$ der in den Zähler Z einlaufenden Zählimpulse.

Im Diagramm b der Figur 5 ist zur Erleichterung des Verständnisses der Verlauf der Ausgangsspannung $u_m$ des Netzwerkes aus Aufnehmer- und Kompensationswiderständen unter der Annahme aufgetragen, daß eine Brückenverstimmung des Meßaufnehmers durch die Meßgröße um $b \cdot \frac{\Delta R}{R}$ durch getaktetes Umschalten des Widerstandes $R_K$ für eine Einschaltzeit $t_e$ von jeweils $b \cdot T_A$ gerade exakt kompensiert wird und der dazu erforderliche Abgleichvorgang abgeschlossen ist. Für diesen Abgleichzustand gilt für jeden Abgleichtakt, unabhängig von der Polarität der Meßaufnehmerspeisespannung $U_S$, daß das den arithmetischen Mittelwert

$$\overline{u_m}_0$$

der Meßschaltungsausgangsspannung $u_m$ vom Einschaltaugenblick $t_{Anfang}$ über eine volle Taktzeit $T_A$ bestimmende Integral

$$\overline{u_m}_0 = \frac{1}{T_A} \int\limits_{t_{Anfang}}^{t_{Anfang} + T_A} u_m(t)\ dt = 0$$

keinen Gleichanteil mehr aufweist. Wird nach einer zunächst als ideal angenommenen Vorverstärkung von

$$u_m{}_0$$

durch den Vorverstärker vom ebenfalls als gesteuerter Umpoler wirkenden phasenempfindlichen Gleichrichter das verstärkte Signal jeweils exakt zu den Zeitpunkten $t_{Anfang}$ umgepolt, kann daher auch in der so gebildeten Ausgangsspannung $u_a$ des phasenempfindlichen Gleichrichters D von diesen Wechselkomponenten von

$$u_m{}_0$$

kein Gleichanteil mehr herrühren, der die Tiefpässe $T_1$ und $T_2$ passieren könnte und dadurch den Abgleichwert der Auswerteschaltung fehlerhaft beeinflussen würde. Dies würde aber sehr wohl passieren, wenn der phasenempfindliche Gleichrichter zu Zeiten umgepolt würde, die nicht exakt mit $t_{Anfang}$ zusammenfallen. Von hier stammt die Forderung nach einer äußerst zeitexakten, phasenstarr, dem Umpoler der Speisespannung zugeordneten Steuerung des Demodulators D.

Im Diagramm c der Figur 5 ist schließlich der real anzutreffende Verlauf der demodulierten Ausgangsspannung $u_a$ des Vorverstärkers VV bei eingangsseitiger Beaufschlagung durch eine Meßschaltungsausgangsspannung $u_m(t)$ entsprechend dem Diagramm b und einer gleichzeitigen

Überlagedieser Spannung $u_m(t)$ durch eine Gleichkomponente $u_o$ infolge von Nulldriften des Vorverstärkers VV sowie von Thermo- und Kontaktspannungen im Meßschaltungskreis aufgetragen. Beide Signalkomponenten erscheinen am Ausgang des Vorverstärkers, um dessen Verstärkungsfaktor $V_1$ vergrößert.

Es ist erkennbar, daß das demodulierte Signal im Abgleichzustand trotz aller Störeinflüsse keinerlei den Abgleichwert mehr beeinflussende Gleichkomponenten aufweist, da der Demodulator die verstärkten Störgleichspannungen in Rechteckwechselspannungen der Grundfrequenz $f_w$ zerhackt. Eine Voraussetzung dafür ist, daß der Demodulator D eine exakt durch 0 gehende, streng lineare Kennlinie aufweist.

In der Figur 6 ist ein weiteres Ausführungsbeispiel für einen direkt gekoppelten Meßgrößenaufnehmer G und einen Kompensationswiderstand $R_{K6}$ dargestellt, bei dem eine Verstimmungskompensation angewendet wird.

An eine Speisespannungsquelle SQ mit der Spannung $2 U_B$ ist ein Umpolschalter SW angeschlossen, der die Speisediagonale eines Meßgrößenaufnehmers G mit einer Rechteckspannung $U_S$ versorgt. Der Meßgrößenaufnehmer G besteht aus einer Brückenschaltung von vier mit einer Meßgröße veränderlichen Widerständen $R_1$... $R_4$. Die Anschlußpunkte dieser Brückenschaltung sind mit 1... 4 benannt. Abweichend von der Schaltung nach Figur 4 ist ein Kompensationswiderstand $R_{K6}$, mit dem eine Verstimmungskompensation des Ausgangssignals des Meßgrößenaufnehmers G erfolgen kann, nicht an einen Eckpunkt der Ausgangsdiagonalen, sondern an einen Speisediagonalpunkt fest angeschlossen. Mit Hilfe eines Umschalters $S_{U6}$ ist der Kompensationswiderstand $R_{K6}$ wechselweise an beide Diagonalpunkte 2, 3 der Ausgangsdiagonalen anschließbar und damit jeweils einem der Brückenwiderstände $R_1$ bzw. $R_3$ parallelzuschalten. Durch diese Umschaltung wird der Abgleichfaktor a so gesteuert, daß die meßgrößenbedingte Verstimmung $\frac{\Delta R}{R}$ der Meßgrößenaufnehmerbrücke G im zeitlichen Mittelwert durch die Gegenverstimmung der Brücke gerade zu 0 gemacht wird. Die momentane Größe der Verstimmung wird mittels der Leerlaufmeßspannung

$$u_{m_o},$$

die an der Ausgangsdiagonalen des Meßgrößenaufnehmers G anfällt und im Vorverstärker VV verstärkt wird, bestimmt. Am Ausgang des Vorverstärkers VV, dessen Betriebsspannung aus der Spannungsquelle SQ stammt, liegt ein weiterer Umschaltkontakt $S_G$, der zusammen mit zwei der Symmetrierung dienenden Widerständen $R_G$ den phasenempfindlichen Gleichrichter oder Demodulator D bildet. Die Ausgangsspannung $U_G$ des Demodulators D wird, wie im Ausführungsbeispiel der Figur 4, weiterverarbeitet. Die Umschalter SW, $S_{U6}$ und $S_G$ werden in der gleichen Weise gesteuert wie die in der Figur 4 als Halbleiterschalter, beispielsweise MOS-FET-Transistoren, dargestellten Schaltelemente $T_{P1}$... $T_{P4}$, $T_{01}$ und $T_{02}$ bzw. $T_{G1}$ und $T_{G2}$.

Ein weiteres Ausführungsbeispiel des Meßgrößenaufnehmer-, Vorverstärker- und phasenempfindlichen Gleichrichterkomplexes mit den zugehörigen Umschaltern und einem Kompensationswiderstand wird in der Figur 7 dargestellt. In ihrer Bedeutung gleichartige Bauelemente sind mit denselben Bezugszeichen wie in der Schaltung nach Figur 6 benannt. Der Meßgrößenaufnehmer G besteht wieder aus vier zu einer Wheatstone-Brückenschaltung zusammengeschalteten Widerständen $R_1$... $R_4$, deren Speisediagonalpunkte 1 und 4 an einer Speisespannung $U_S$ liegen, die über den periodisch schaltbaren Umschalter SW an der Speisequelle SQ mit der Gleichspannung $2 U_B$ liegen. Am Ausgangsdiagonalpunkt 3 der Meßgrößenaufnehmerbrücke G ist die Brücke aufgetrennt und in die Trennstellen 3a, 3b ein Kompensationswiderstand $R_{K7}$ eingefügt. Der Meßgrößenaufnehmer G ist hier als Vollbrückenschaltung dargestellt, es versteht sich jedoch von selbst, daß auch eine Viertel- oder Halbbrückenschaltung verwendet werden kann. Die Brückenpunkte 3a und 3b können wechselweise mit Hilfe eines Umschalters $SU_7$ an den einen Eingang des Vorverstärkers VV gelegt werden, dessen anderer Eingang mit dem Ausgangsdiagonalpunkt 2 des Meßgrößenaufnehmers G verbunden ist. Die am Widerstand $RK_7$ abfallende Teilspannung

$$\hat{u}_K = U_S \cdot \frac{R_U}{2R + R_U}$$

wird durch Umschalten von $S_{U7}$ im Zeitverhältnis $a = t_e/T_A$ der Meßaufnehmerspannung $u_m$ nach dem Prinzip der Spannungskompensation entgegengeschaltet.

Die übrige nicht dargestellte Schaltung zur Auswertung der Ausgangsspannung des phasenempfindlichen Gleichrichters D sowie für die Steuerung der Umschalter entspricht den aus der Figur 4 entnehmbaren Einzelheiten.

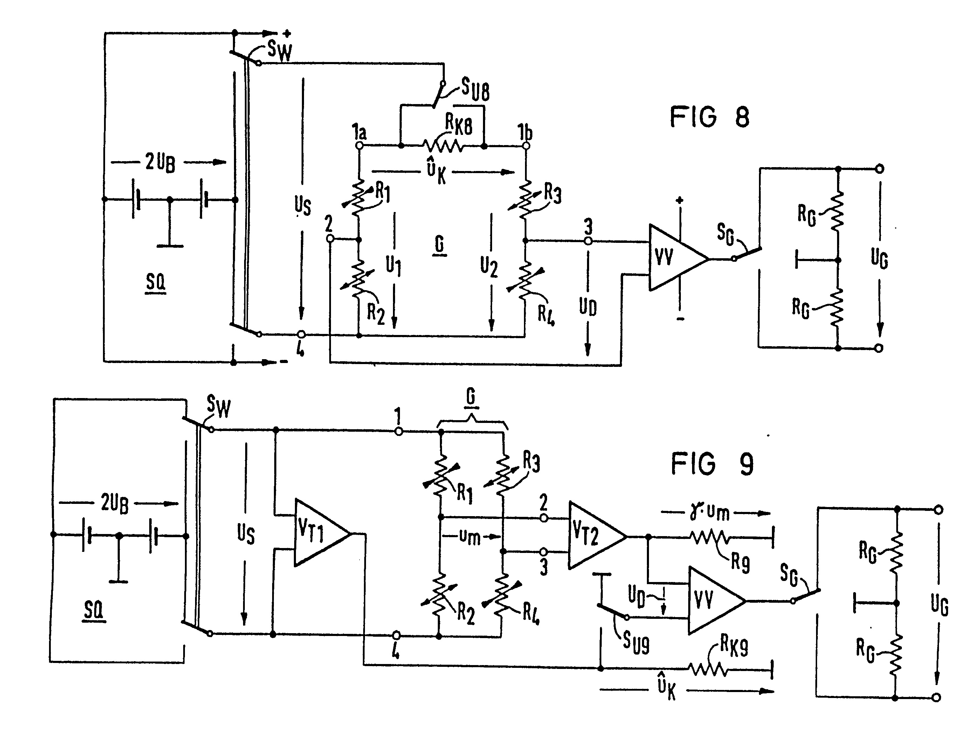

Eine mit der Schaltung nach Figur 7 weitgehend übereinstimmende Schaltung ist in Figur 8 dargestellt. Sie unterscheidet sich von der Schaltung nach Figur 7 dadurch, daß der Speisediagonalpunkt 1 der Meßgrößenaufnehmerbrücke G aufgetrennt ist und an der Trennstelle 1a, 1b ein Kompensationswiderstand $R_{K8}$ eingefügt ist. Ein Umschalter $S_{U8}$ legt abwechslungsweise einen der Punkte 1a bzw. 1b an die Ausgangsspannung $U_S$ des Umpolschalters SW. Auch bei der Schaltung nach Figur 8 liegt eine Spannungskompensation vor. Die Eingangsspannung $u_D$ für den Vorverstärker beträgt $u_D = U_1 - U_2 = u_m - a \cdot \hat{u}_K$.

In Figur 9 ist ein weiterer Meßgrößenaufnehmerkompensations- und Gleichrichterkomplex gezeigt, der nach dem Prinzip einer Spannungskompensation arbeitet. Dabei wird die Spannung $u_m$ an der Ausgangsdiagonalen des Meßgrößenaufnehmers G über einen Operationsverstärker $V_{T2}$ verstärkt. Ein Kompensationswiderstand $R_{K9}$ liegt über einen anderen Operationsverstärker $V_{T1}$ an der Ausgangsspannung $U_S$ des Umpolschalters SW. Eine der Eingangsklemmen des Vorverstärkers VV liegt am Ausgang des Operationsverstärkers $V_{T2}$, die andere Eingangsklemme wird über einen Umschalter $S_{U9}$ abwechselnd mit dem Spannungsabfall $\hat{u}_K$ am

10

Kompensationswiderstand $R_{K9}$ und Nassepotential beäufschlagt. Die Eingangsspannung des Vorverstärkers VV stellt sich dar zu

$$u_D = v \cdot u_m - a \cdot \hat{u}_K$$

wobei v die Verstärkung des Operationsverstärkers $V_{T2}$ bedeutet.

In der Figur 10 wird ein Schaltungsbeispiel für ein Meßgrößenaufnehmer- und Kompensationsnetzwerk dargestellt, das nach dem Prinzip der Stromkompensation arbeitet. Dazu sind eine Meßgrößenaufnehmer-Brückenschaltung G und eine Kompensationsbrückenschaltung K, die aus vier Widerständen $R_1'$... $R_4'$ und einem umschaltbaren Widerstand $R_{K10}$ besteht, mit ihren Speisediagonalen und Ausgangsdiagonalen parallelgeschaltet. Speiseseitig liegen beide am Umpolschalter SW und damit an dessen Ausgangsspannung $U_S$. Einer der Ausgangsdiagonalpunkte der Kompensationsbrücke K ist aufgetrennt, zwischen den Trennstellen liegt der umschaltbare Widerstand $R_{K10}$, dessen beide Anschlußpunkte abwechselnd von einem Umschalter $S_{U10}$ an den einen Eingang des Vorverstärkers VV gelegt werden. Der andere Eingang des Vorverstärkers VV liegt an zwei miteinander verbundenen Ausgangsdiagonalpunkten der beiden Brückenschaltungen G und K. Bei dieser Schaltungsanordnung wird ein Kurzschlußstrom $i_m$ aus den Meßdiagonalen der Meßgrößenaufnehmerbrücke G gegen den Kurzschlußstrom $i_k$ der Kompensationsbrückenschaltung K kompensiert. Im Interesse geringer Rückwirkung auf die Aufnehmerbrückenschaltung und geringer Belastung der Stromquelle SQ sind alle Brückenwiderstände der Kompensationsbrückenschaltung K hochohmig ausgelegt.

Eine Variante der Schaltung nach Figur 10 ist in der Figur 11 dargestellt. Die Brückenschaltung K ist dabei zu einer Halbbrücke aus den Widerständen $R_3'$ und $R_4'$ mit dem zwischengefügten umschaltbaren Widerstand $R_{K11}$ reduziert worden. Zu dieser Variante kommt man einfach, wenn die Widerstände $R_1'$ und $R_2'$ der Schaltung nach Figur 10 unendlich groß gemacht werden.

Ein weiteres Ausführungsbeispiel, bei dem eine Stromkompensation mit einer Kompensationsbrückenschaltung Anwendung findet, ist in der Figur 12 schematisch dargestellt. Dabei ist nur die Kompensationsbrücke K aus den Widerständen $R_1'$... $R_4'$ und ihr Anschluß an den aus den Widerständen $R_3$ und $R_4$ bestehenden Brückenzweig der Meßgrößenaufnehmerbrücke G gezeigt. Ein Umschaltwiderstand $S_{U12}$ gestattet dabei, die Kompensationsbrückenschaltung K im Takt des Abgleichfaktors $a = t_e/T_A$ an die Speisespannung zu legen.

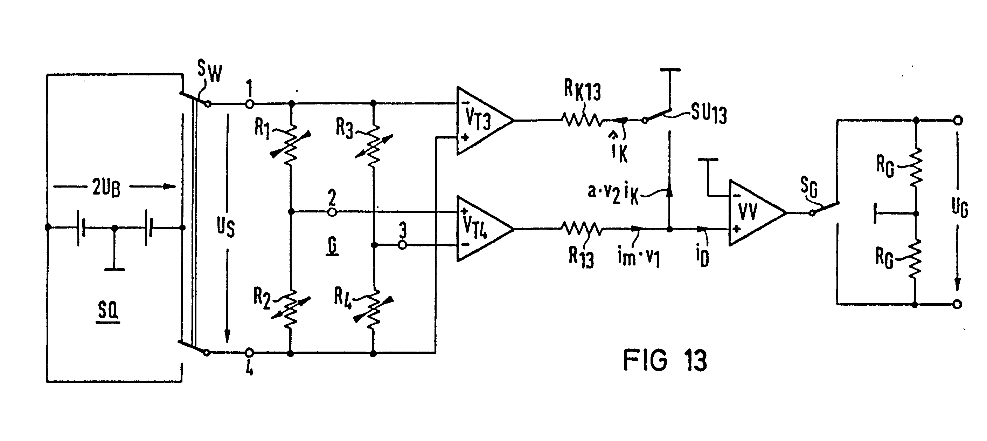

In der Figur 13 ist noch ein Beispiel für eine Stromkompensation des Meßgrößenaufnehmerausgangssignals dargestellt. Dabei liegen die Ausgangsdiagonalpunkte 2 und 3 der Meßgrößenaufnehmer-Brückenschaltung G an den beiden Eingängen eines Operationsverstärkers $V_{T4}$, dessen Ausgang über einen Widerstand an dem einen Eingang des Vorverstärkers VV liegt. Die periodisch umgeschaltete Speisespannung $U_S$ liegt an den Eingängen eines weiteren Operationsverstärkers $V_{T3}$, dessen Ausgang über einen Widerstand und einen Umschalter $S_{U13}$ abwechselnd mit Masse und dem schon erwähnten Eingang des Vorverstärkers VV verbindbar ist. Der andere Eingang des Vorverstärkers VV liegt an Masse.

Die dargestellten Ausführungsbeispiele weisen alle das Merkmal der gleichspannungsmäßig durchlässigen Kopplung von Meßgrößenaufnehmer- und Kompensationsnetzwerk an den Polumschalter SW auf. Die dargestellten Möglichkeiten der Ausgestaltung der Kompensation erhebt keinen Anspruch auf Vollständigkeit. Es ist möglich, aus den hier beschriebenen Grundlösungen Mischschaltungsanordnungen abzuleiten, bei denen ebenfalls die der Erfindung zugrunde liegenden Maßnahmen angewendet werden.

**Patentansprüche**

1. Auswerteschaltungen für passive Meßgrößenaufnehmer (DMS1, DMS2) mit ohmschen Fühlerwiderständen in Brückenschaltungen mit einem Abgleich der Ausgangsignale der Aufnehmer durch dauermoduliertes Umschalten eines Widerstandes ($R_K$), der vom Überlaufsignal eines Taktimpulszählers (Z2) in die eine Umschaltlage und vom Ausgangssignal eines digitalen Vergleichers (DV) der Inhalte des Taktimpulszählers (Z2) und eines an den Ausgang eines vorzeichenempfindlichen Spannungs-Frequenz-Umformers (SPF), dessen Eingangsspannung aus einem verstärkten, mit einem phasenempfindlichen Gleichrichter (D) gleichgerichteten und durch einen Tiefpaß (TP) gefilterten Abgleichdifferenzsignal besteht, angeschlossenen Vor-Rückwärtszählers (Z1) in die andere Umschaltlage gesteuert wird, bei denen die Aufnehmer und der umschaltbare Widerstand ($R_K$) mit einem vom Überlauf des Taktimpulszählers (Z2) gesteuerten Polumschalter (SW) auf einer Gleichstrom- oder Gleichspannungsquelle ($U_B$) gespeist sind und der phasenempfindliche Gleichrichter (D) Synchron mit dem Polumschalter gesteuert ist, gekennzeichnet durch die Kombination folgender Merkmale:

a) für die Verstärkung des Abgleichdifferenzsignals ist vor dem phasenempfindlichen Gleichrichter (D) ein auch Gleichkomponenten übertragender Vorverstärker (VV), der im gesamten Übertragungsbereich einen phasenlinearen Frequenzgang sowie eine hochlineare Aussteuerkennlinie aufweist, und nach dem Gleichrichter (D) ein Nullverstärker (NV) vorgesehen;

b) mindestens der umschaltbare Widerstand ($R_K$) ist mit dem Polumschalter (SW) über für Gleichkomponenten durchlässige Mittel gekoppelt.

2. Auswerteschaltungen nach Anspruch 1, dadurch gekennzeichnet, daß der phasenempfindliche Gleichrichter (D) eine streng lineare Kennlinie aufweist, die exakt durch den Nullpunkt verläuft.

3. Auswerteschaltungen nach Anspruch 1, dadurch gekennzeichnet, daß die Meßgrößenaufnehmer-Brückenschaltung (G) und/oder der umschaltbare Widerstand ($R_K$) mit dem Polumschalter (SW) galvanisch gekoppelt sind.

4. Auswerteschaltungen nach Anspruch 1, dadurch gekennzeichnet, daß die Meßgrößenaufnehmer-Brückenschaltung (G) und/oder der umschaltbare Widerstand ($R_K$) über Operationsverstärker mit dem Polumschalter (SW) gekoppelt sind.

5. Auswerteschaltungen nach Anspruch 1, dadurch gekennzeichnet, daß die Aufnehmerbrückenschaltung (G) und/oder der umschaltbare Widerstand ($R_K$) mit dem Polumschalter (SW) über Optokoppler gekoppelt sind.

6. Auswerteschaltungen nach Anspruch 3, dadurch gekennzeichnet, daß die mit ihrer Speisediagonalen galvanisch an den Polumschalter (SW) gekoppelte Meßgrößenaufnehmer-Brückenschaltung (G) an einem ihrer Diagonalpunkte (3 bzw. 1) aufgetrennt und der umschaltbare Widerstand ($R_{K7}$ bzw. $R_{K8}$) in die Trennstelle eingefügt ist, wobei der Umschaltkontaktarm des Umschalters ($S_{U7}$ bzw. $R_{K8}$) den Diagonalpunkt an der Trennstelle ersetzt und die Eingangsklemmen des Vorverstärkers (VV) an der Meßdiagonalen der Meßgrößenaufnehmer-Brückenschaltung (G) liegen.

7. Auswerteschaltungen nach Anspruch 4, dadurch gekennzeichnet, daß die Speisediagonale der Meßgrößenaufnehmer-Brückenschaltung (G) galvanisch mit dem Polumschalter (SW) gekoppelt ist, der umschaltbare Widerstand ($R_{K9}$) zwischen den Ausgang eines mit seinen Eingangsklemmen am Polumschalter (SW) liegenden ersten Operationsverstärkers ($V_{T1}$) und Masse geschaltet ist, daß die Meßdiagonale der Meßgrößenaufnehmer-Bruckenschaltung (G) an den Eingangsklemmen eines zweiten Operationsverstärkers ($V_{T2}$) liegt, dessen Ausgang über einen Widerstand mit Masse verbunden ist und an einer der Eingangsklemmen des Vorverstärkers (VV) liegt, der mit seiner anderen Eingangsklemme an den Umschaltkontaktarm des Umschalters ($S_{U9}$) angeschlossen ist, der in der einen Stellung am Ausgang des ersten Operationsverstärkers ($V_{T1}$) und in der anderen Stellung an Masse liegt.

8. Auswerteschaltungen nach Anspruch 4, dadurch gekennzeichnet, daß die Speisediagonale der Meßgrößenaufnehmer-Brückenschaltung (G) galvanisch mit dem Polumschalter (SW) gekoppelt ist, der umschaltbare Widerstand ($R_{K13}$) über den Umschalter ($S_{U13}$) zwischen den Ausgang eines mit seinen Eingangsklemmen am Polumschalter (SW) liegenden ersten Operationsverstärkers ($V_{T3}$) und Masse geschaltet ist, daß die Meßdiagonale der Meßgrößenaufnehmer-Brückenschaltung (G) an den Eingangsklemmen eines zweiten Operationsverstärkers ($V_{T4}$) liegt, dessen Ausgang über einen Widerstand ($R_{13}$) an derjenigen Eingangsklemme des Vorverstärkers (VV) liegt, die mit einem der Umschaltkontakte des Umschalters ($S_{U13}$) verbunden ist, und der Vorverstärker (VV) mit der anderen Eingangsklemme an Masse liegt.

9. Auswerteschaltungen nach Anspruch 3, dadurch gekennzeichnet, daß der Meßgrößenaufnehmer-Brückenschaltung (G) speise- und meßdiagonalseitig eine zweite Widerstandsbrückenschaltung (K) parallelgeschaltet ist, wobei die zweite Widerstandsbrückenschaltung (K) an einem Meßdiagonalpunkt aufgetrennt und der umschaltbare Widerstand ($R_{K10}$) in die Trennstelle eingefügt ist, und daß die Eingangsklemmen des Vorverstärkers (VV) an den parallelgeschalteten Meßdiagonalen der beiden Widerstandsbrückenschaltungen (G, K) angeschlossen sind.

10. Auswerteschaltungen nach Anspruch 9, dadurch gekennzeichnet, daß anstelle der zweiten-Widerstandsbrücke eine Halbbrücke tritt, deren Zweige ($R_3'$, $R_4'$) den umschaltbaren Widerstand ($R_{K11}$) einschließen.

11. Auswerteschaltungen nach Anspruch 3, dadurch gekennzeichnet, daß der Meßgrößenaufnehmer-Brückenschaltung eine zweite Widerstandsbrücke (K) speise- und meßdiagonalseitig parallelgeschaltet ist, die an einem Speisediagonalpunkt aufgetrennt ist und die Trennstelle von zwei Kontakten des Umschalters ($S_{U12}$) besetzt ist, wobei die Speiseleitung am Umschaltkontaktarm des Umschalters ($S_{U12}$) liegt, und daß die Eingangsklemmen des Vorverstärkers (VV) an den parallelgeschalteten Meßdiagonalen der beiden Widerstandsbrückenschaltungen (G, K) angeschlossen sind.

12. Auswerteschaltungen nach Anspruch 3, dadurch gekennzeichnet, daß der Umschaltwiderstand ($R_K$) mit Hilfe des Umschalters ($T_{01}$, $T_{02}$) abwechselnd zwei zu einem Diagonalpunkt symmetrisch liegenden Widerständen der Meßgrößenaufnehmer-Brückenschaltung (G) parallelschaltbar ist und die Eingangsklemmen des Vorverstärkers (VV) an der Meßdiagonalen liegen.

13. Auswerteschaltungen nach Anspruch 1, dadurch gekennzeichnet, daß ein Generator (TG) für die hochfrequente Impulsfolge quarzstabilisiert ist.

14. Auswerteschaltungen nach Anspruch 2, dadurch gekennzeichnet, daß die Symmetrie zweier Zweige des phasenempfindlichen Gleichrichters (D) gegenüber Masse durch ein Potentiometer (PL) justierbar ist.

## Claims

1. Analysing circuits for passive measured value receivers (DMS1, DMS2) having ohmic sensor impedances in bridge connections wich adjustment of the output signals of the receivers provided by continuously modulated change-over of a resistor ($R_K$), which is controlled into one change-over position by the overflow signal of a clock pulse counter (Z2) and into the other change-over position by the output signal of a digital comparator (DV) that compares the contents of the clock pulse counter (Z2) and a forward/backward counter (Z1) connected to the output of a sign-sensitive voltage-frequency transformer (SPF), whose input voltage consists of an amplified balancing difference signal that is rectified by a phase-sensitive rectifier (D) and filtered by a low-pass filter (TP), in which analysing circuits the receivers and the switchable resistor ($R_K$) with its change-over switch (SW) controlled by the overflow of the clock pulse counter (Z2) are fed from a d.c. current or voltage source ($U_B$) and the phase-sensitive rectifier (D) is synchronously controlled with the change-over switch, <u>characterised by</u> the combination of the following features:

a) in order to amplify the balancing difference signal the phase-sensitive rectifier (D) is preceded by a preamplifier (VV) that transmits d.c. components and operates over the entire transmission region with a phase-linear frequency-response curve together with a highly linear modulation characteristic followed by a zero amplifier (NV); and

b) at least the switchable resistor ($R_K$) is connected to the change-over switch (SW) by d.c. coupled devices.

2. Analysing circuits as claimed in Claim 1, <u>characterised in that</u> the phase-sensitive rectifier (D) has a strictly linear characteristic which runs exactly through the zero point.

3. Analysing circuits as claimed in Claim 1, <u>characterised in that</u> the measured value receiver bridge circuit (G) and/or the switchable resistor ($R_K$) are d.c. coupled to the change-over switch (SW).

4. Analysing circuits as claimed in Claim 1, <u>characterised in that</u> the measured value receiver bridge circuit (G) and/or the switchable resistor ($R_K$) are connected to the change-over switch (SW) by means of operational amplifiers.

5. Analysing circuits as claimed in Claim 1, <u>characterised in that</u> the receiver bridge circuit (G) and/or the switchable resistor ($R_K$) are connected to the change-over switch (SW) by opto-couplers.

6. Analysing circuits as claimed in Claim 3, <u>characterised in that</u> the measured value receiver bridge circuit (G) which has its feed diagonal d.c. coupled to the change-over switch (SW) is divided at one of its diagonal points (3 or 1) and the switchable resistor ($R_{K7}$ or $R_{K8}$) inserted into the separating point, where the switching contact arm of the reverser ($S_{U7}$ or $R_{K8}$) replaces the diagonal point at the separating point and the input termninals of the preamplifier (VV) are arranged on the measuring diagonal of the measured value receiver bridge circuit (G).

7. Analysing circuits as claimed in Claim 4, <u>characterised in that</u> the feed diagonal of the measured value receiver bridge circuit (G) is galvanically connected to the change-over switch (SW), the switchable resistor ($R_{K9}$) is connected between earth and the output of a first operational amplifier ($V_{T1}$) whose input terminals are arranged on the change-over switch (SW), that the measuring diagonal of the measured value receiver bridge circuit (G) is arranged on the input terminals of a second operational amplifier ($V_{T2}$), whose output is connected to earth via a resistor and arranged on one of the input terminals of the preamplifier (VV), which has its other input terminal connected to the switching contact arm of the reverser ($S_{U9}$) which in the one position is connected to the output of the first operational amplifier ($V_{T1}$) and to earth in the other position.

8. Analysing circuits as claimed in Claim 4, <u>characterised in that</u> the feed diagonal of the measured value receiver bridge circuit (G) is d.c. coupled to the change-over switch (SW), the switchable resistor ($R_{K13}$) is connected via the reverser ($S_{U13}$) between the output of a first operational amplifier ($V_{T3}$), which has its input terminals connected to the change-over switch (SW) and earth, that the measuring diagonal of the measured value receiver bridge circuit (G) is arranged on the input terminals of a second operational amplifier ($V_{T4}$) whose output is connected via a resistor ($R_{13}$) to that input terminal of the preamplifier (VV) which is connected to one of the switching contacts of the reverser ($S_{U13}$), and the preamplifier (VV) is connected to earth by the other input terminal.

9. Analysing circuits as claimed in Claim 3, <u>characterised in that</u> a second resistor bridge circuit (K) is connected in parallel to the measured value receiver bridge circuit (G) at the supply end and the measuring diagonal end, where the second resistor bridge circuit (K) is divided at a measuring diagonal point, the switchable resistor ($R_{K10}$) is inserted into the separating point, and that the input terminals of the preamplifier (VV) are connected to the parallel measured diagonals of the two resistor bridge circuits (G, K).

10. Analysing circuits as claimed in Claim 9, <u>characterised in that</u> a semi-bridge, whose branches ($R_3'$, $R_4'$) comprise the switchable resistor ($R_{K11}$), replaces the second resistor bridge.

11. Analysing circuits as claimed in Claim 3, <u>characterised in that</u> at the supply end and the measuring diagonal end a second resistor bridge (K) is connected parallel to the measured value receiver bridge circuit, which resistor bridge is divided at a feed diagonal point and the separating point is occupied by two contacts of the reverser ($S_{U12}$), where the feed line is arranged on the switching contact arm of the reverser ($S_{U12}$), and that the input terminals of the preamplifier (VV) are connected to the parallel measured diagonals of the two resistor bridge circuits (G, K).

12. Analysing circuits as claimed in Claim 3, <u>characterised in that</u> with the aid of a reverser ($T_{01}$, $T_{02}$) the switchable resistor ($R_K$) can be alternately connected in parallel to two resistors of the measured value receiver bridge circuit (G), which are symmetrically arranged relative to a diagonal point, and the input terminals of the preamplifier (VV) are arranged on the measuring diagonal.

13. Analysing circuits as claimed in Claim 1, <u>characterised in that</u> a generator (TG) for a high-frequency pulse train is quartz-stabilised.

14. Analysing circuits as claimed in Claim 2, <u>characterised in that</u> the symmetry of two branches of the phase-sensitive rectifier (D) is adjustable with respect to earth by a potentiometer (PL).

## Revendications

1. Circuits d'évaluation pour des capteurs de mesure passifs (DMS1, DMS2) comportant des résistances ohmiques de détection montées selon des montages en pont avec un équilibrage des signaux de sortie des capteurs au moyen d'une commutation, modulée en durée, d'une résistance ($R_K$), qui est placée dans une position de commutation par le signal de dépassement de capacité d'un compteur d'impulsions de cadence (Z2) et dans l'autre position de commutation par le signal de sortie d'un comparateur numérique (DV) et des contenus du compteur d'impulsions de cadence (Z2) et d'un compteur progressif-régressif (Z1), qui est raccordé à la sortie d'un convertisseur tension-fréquence (SPF) sensible au signe et dont la tension d'entrée est constituée par un signal amplifié de différence d'équilibrage, redressé par un redresseur (D) sensible à la phase et filtré par un filtre passe-bas (TP), et dans lesquels le capteur et la résistance commutables ($R_K$) sont alimentés par un inverseur de polarité (SW) commandé par le dépassement de capacité du compteur d'impulsions de cadence (Z2), à partir d'une source ($U_V$) de courant continu ou de tension continue et le redresseur (D) sensible à la phase est commandé en synchronisme avec l'inverseur de polarité, caractérisés par la combinaison des caractéristiques suivantes:

a) pour l'amplification du signal de différence d'équilibrage, il est prévu, en amont du redresseur (D) sensible à la phase, un préamplificateur (VV) transmettant également des composantes continues et qui comporte, dans l'ensemble de la plage de transmission, une réponse en fréquence linéaire du point de vue de la phase ainsi qu'une caractéristique de modulation quasiment linéaire, et, en aval du redresseur (D), un amplificateur de zéro (NV);

b) au moins la résistance commutable ($R_K$) est accouplée à l'inverseur de polarité (SW) par l'intermédiaire de moyens transmettant des composantes continues.

2. Circuits d'évaluation suivant la revendication 1, caractérisés par le fait que le redresseur (D) sensible à la phase possède une caractéristique strictement linéaire qui passe de façon précise par l'origine.

3. Circuits d'évaluation suivant la revendication 1, caractérisés par le fait que le circuit en pont (G) des capteurs de mesure et/ou la résistance commutable ($R_K$) sont couplés galvaniquement à l'inverseur de polarité (SW).

4. Circuits d'évaluation suivant la revendication 1, caractérisés par le fait que le circuit en pont (G) constituant le capteur et/ou la résistance commutable ($R_K$) sont couplés par l'intermédiaire d'amplificateurs opérationnels à l'inverseur de polarité (SW).

5. Circuits d'évaluation suivant la revendication 1, caractérisé par le fait que le circuit en pont (G) constituant le capteur de mesure et/ou la résistance commutable ($R_K$) sont couplés à l'inverseur de polarité (SW) par l'intermédiaire d'optocoupleurs.

6. Circuits d'évaluation suivant la revendication 3, caractérisés par le fait que le circuit en pont (G) constituant le capteur de mesure couplé ganvaniquement par sa diagonale d'alimentation, à l'inverseur de polarité (SW), est interrompu au niveau d'un point (3 ou 1) de sa diagonale et que la résistance commutable ($R_{K7}$ ou $R_{K8}$) est insérée dans la zone d'interruption, auquel cas le bras de contact de commutation du commutateur ($S_{U7}$ ou $R_{K8}$) remplace le joint des diagonales au niveau de la zone d'interruption et les bornes d'entrée du préamplificateur (VV) sont situées dans la diagonale de mesure du circuit en pont (G) constituant le capteur de mesure.

7. Circuits d'évaluation suivant la revendication 4, caractérisés par le fait que la diagonale d'alimentation des circuits en pont (G) constituant le capteur de mesure est couplée galvaniquement à l'inverseur de polarité (SW), que la résistance commutable ($R_{K9}$) est branchée entre la sortie d'un premier amplificateur opérationnel ($V_{T1}$) raccordé par ses bornes d'entrée à l'inverseur de polarité (SW) et la masse, que la diagonale de mesure du circuit en pont (G) constituant le capteur de mesure est raccordé aux bornes d'entrée d'un second amplificateur opérationnel ($V_{T1}$), dont la sortie est reliée par l'intermédiaire d'une résistance à la masse et est raccordée à l'une des bornes d'entrée du préamplificateur (VV), qui est raccordé, par son autre borne d'entrée, au bras du contact de commutation du commutateur ($S_{U9}$), qui dans une position, est raccordé à la sortie du premier amplificateur opérationnel ($V_{T1}$) et, dans son autre position est raccordé à la masse.

8. Circuit d'évaluation suivant la revendication 4, caractérisé par le fait que la diagonale d'alimentation du circuit en pont (G) constituant le capteur de mesure est couplé galvaniquement à l'inverseur de polarité (SW), que la résistance commutable ($R_{K13}$) est branchée par l'intermédiaire du commutateur ($S_{U13}$) entre la sortie d'un premier amplificateur opérationnel ($V_{T3}$), raccordé par ses bornes d'entrée à l'inverseur de polarité (SW), et la masse, que la diagonale de mesure du circuit en pont (G) constituant le capteur de mesure est raccordée aux bornes d'entrée d'un second amplificateur opérationnel ($V_{T4}$) dont la sortie est raccordée par l'intermédiaire d'une résistance ($R_{13}$) à la borne d'entrée du préamplificateur (VV), qui est reliée à l'un des contacts de commutation du commutateur ($S_{U13}$) et que le préamplificateur (VV) est raccordé par l'autre borne d'entrée à la masse.

9. Circuits d'évaluation suivant la revendication 3, caractérisés par le fait que du côté de l'alimentation et du côté de la diagonale de mesure, un second circuit en pont (K) formé de résistances est branché en parallèle avec le circuit en pont (G) constituant le capteur de mesure, auquel cas le second circuit en pont (K) formé de résistances est interrompu au niveau d'un point de la diagonale de mesure et que la résistance commutable ($R_{K10}$) est insérée dans la zone d'interruption, et que les bornes d'entrée du préamplificateur (VV) sont raccordées aux diagonales de mesure branchées en parallèle, des deux circuits en pont (G, K) formés de résistances.

10. Circuits d'évaluation suivant la revendication 9, caractérisé par le fait qu'à la place du second pont formé de résistances, il est prévu un demi-pont, dont les branches ($R_3'$, $R_4'$) contiennent la résistance commutable ($R_{K11}$).

11. Circuits d'évaluation suivant la revendication 3, caractérisés par le fait qu'en parallèle avec le circuit en pont constituant le capteur de mesure se trouve branché, sur le côté alimentation et sur le côté de la diagonale de mesure, un second pont (K) formé de résistances, qui est séparé au niveau d'un point de la diagonale d'alimentation et que la zone de séparation est occupée par deux contacts inverseurs ($S_{U12}$), la ligne d'alimentation étant raccordée au bras du contact de commutation du commutateur ($S_{U12}$), et que les bornes d'entrée du préamplificateur (VV) sont raccordées aux diagonales de mesure branchées en parallèle, des deux circuits en pont (G, K) formés de résistances.

12. Circuits d'évaluation suivant la revendication 3, caractérisés par le fait que la résistance de commutation ($R_K$) peut être branchée en alternance, à l'aide du commutateur ($T_{01}$, $T_{02}$), en parallèle avec deux résistances, disposées symétriquement par rapport à un point de la diagonale, du circuit en pont (G) constituant le capteur de mesure et que les bornes d'entrée du préamplificateur (VV) sont raccordées à la diagonale de mesure.

13. Circuits d'évaluation suivant la revendication 1, caractérisés par le fait qu'un générateur (TG) pour le train d'impulsions à haute fréquence est stabilisé par quartz.

14. Circuits d'évaluation suivant la revendication 2, caractérisé par le fait que la symétrie de deux branches du redresseur (D) sensible à la phase par rapport à la masse peut être ajustée par l'intermédiaire d'un potentiomètre (PL).

**FIG. 1**

FIG 2

FIG 3

FIG 4

FIG 5

FIG 6

FIG 7

FIG 8

FIG 9

0 141 080

FIG 10

FIG 11

FIG 12

0 141 080

FIG 13